# EUROPÄISCHE PATENTSCHRIFT

(11) **EP 1 057 258 B1**
(45) Veröffentlichungstag und Bekanntmachung des Hinweises auf die Patenterteilung: **30.10.2002**
(21) Anmeldenummer: 99915480.0
(22) Anmeldetag: 16.02.1999
(51) Int. Cl.: H03H 9/05

(54) **ELEKTRONISCHES BAUELEMENT, INSBESONDERE MIT AKUSTISCHEN OBERFLÄCHENWELLEN ARBEITENDES BAUELEMENT - OFW-BAUELEMENT**
ELECTRONIC COMPONENT, ESPECIALLY A COMPONENT WORKING WITH ACOUSTIC SURFACE WAVES
COMPOSANT ELECTRONIQUE, NOTAMMENT COMPOSANT A ONDES DE SURFACE, FONCTIONNANT AVEC DES ONDES DE SURFACE ACOUSTIQUES

(30) Priorität: 17.02.1998 DE 19806550
(43) Veröffentlichungstag der Anmeldung: 06.12.2000
(73) Patentinhaber: EPCOS AG, 81541 München (DE)
(72) Erfinder: STELZL, Alois, D-81549 München (DE); KRÜGER, Hans, D-81737 München (DE); WEIDNER, Karl, D-81245 München (DE); WOSSLER, Manfred, D-81479 München (DE)
(74) Vertreter: Epping, Wilhelm, Dipl.-Ing.
(86) Internationale Anmeldenummer: DE9900420
(87) Internationale Veröffentlichungsnummer: WO99041833

(56) Entgegenhaltungen:
- EP-A- 0 643 482
- DE-A- 19 548 051
- DE-A- 19 548 062

## Beschreibung

Die vorliegende Erfindung betrifft ein elektronisches Bauelement, insbesondere ein mit akustischen Oberflächenwellen arbeitendes OFW-Bauelement.

Elektronische Bauelemente der vorstehend genannten Art besitzen üblicherweise Chips mit einem piezoelektrischen Substrat und mit auf dem Substrat angeordneten elektrisch leitenden Strukturen, insbesondere aktiven Filterstrukturen, wie z.B. Interdigital-Wandlern, Anschlußbahnen, sogenannten pads - und dergl. Die elektrische Kontaktierung dieser Strukturen mit äußeren Anschlußelementen erfolgt wiederum über Leiterbahnen, die auf eine Trägerplatte des Chips, z.B. auf eine Keramik-oder Kunststoffplatte, aufgebracht sind.

Aus der DE 195 48 051 A1 ist ein elektronisches Bauelement, insbesondere ein Oberflächenwellenbauelement bekannt, bei dem ein Teil der leitfähigen Strukturen auf dem Bauelement mit einer kappenförmigen Abdeckung verschlossen ist, die einen Hohlraum zum Substrat hin ausbildet, in dem die gegen Umwelteinflüsse empfindlichen Bauelementstrukturen angeordnet sind.

Eine ähnliche kappenförmige Abdeckung für elektronische Bauelemente ist aus der DE 195 48 062 A1 bekannt. Zusätzlich ist auf dieser Abdeckkappe eine Metallisierung vorgesehen, die mittels einer Durchkontaktierung mit einer Anschlußfläche auf dem Bauelementsubstrat verbunden ist. Die Metallisierung dient zur HF-Abschirmung und kann lötfähig ausgebildet sein. Das Bauelement ist für eine Flip-Chip-Montage geeignet.

Aus der EP 0 643 482 A1 ist ein Oberflächenwellenbauelement in einem Glasgehäuse bekannt, welches eine Abdeckplatte aufweist. Auf der Abdeckplatte ist ein elektrischer Leiter angeordnet, der über eine Bump-Verbindung elektrisch leitend mit dem Bauelement verbunden ist.
Im Zuge der stetig zunehmenden Miniaturisierung der Bauelemente, d.h. bei weiterer Verringerung der Abmessungen von OFW-Bauelementen bis hin zu Chip-Abmessungen kleiner 3 x 3 mm verursacht der nicht in gleichem Maße reduzierbare Platzbedarf für die elektrische Kontaktierung des Bauelements erhebliche Probleme, insbesondere wenn die Bauelemente mit gegebenenfalls mehrlagigen, üblicherweise 2-lagigen, strukturierten Schutzfolien - anmelderseits auch PROTEC genannt - gegen physikalische und chemische Umwelteinflüsse und Feuchtigkeit geschützt sind.

Die vorliegende Erfindung hat sich zur Aufgabe gestellt, eine Lösung zu schaffen, welche die weitere Miniaturisierung der OFW-Bauelemente zuläßt, ohne daß dabei die Schutzwirkung der Schutzfolie und die Wirksamkeit der Kontaktelemente und der OFW-Bauelemente insgesamt beeinträchtigt wird.
Diese Aufgabe wird erfindungsgemäß durch ein Bauelement mit den Merkmale Anspruch 1 gelöst. D.h. es wird der Forderung nach minimalen Chip-Abmessungen durch die Verlagerung der elektrischen Kontaktelemente in die Ebene über der Schutzfolie genügt.

Weiterbildungen der Erfindung sind Gegenstand von Unteransprüchen.

Die Erfindung wird nachstehend anhand der Zeichnung näher erläutert. Es zeigt:
- Fig. 1:: in teils gebrochener und geschnittener Seitenansicht einen Wafer mit einem Chip;
- Fig. 2:: eine Draufsicht auf einen Chip gemäß Fig. 1; und
- Fig. 3:: in teils geschnittener Seitenansicht einen Chip gemäß Fig. 1, 2 samt Basisplatte.

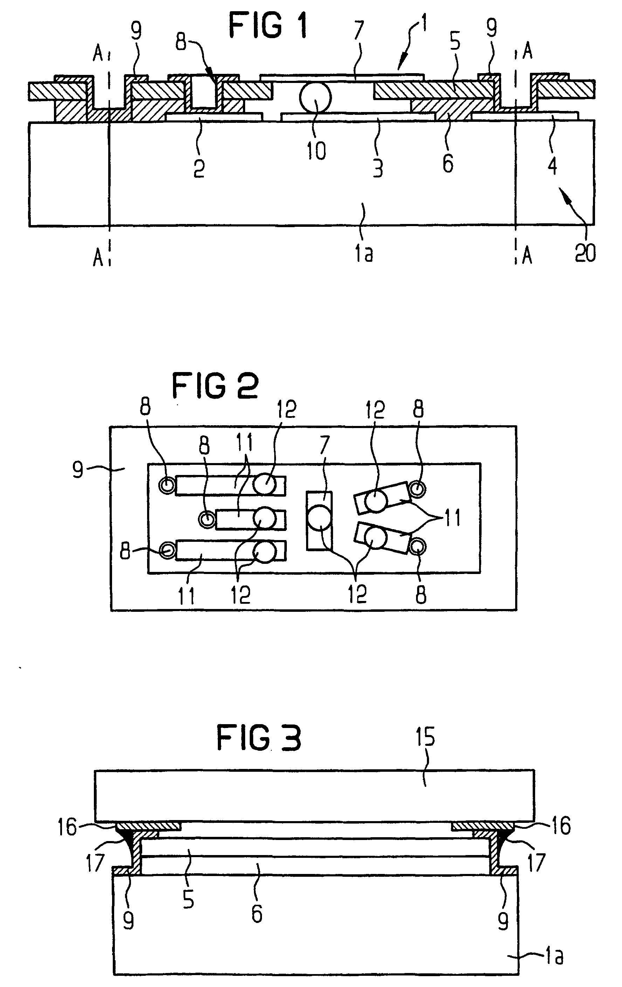

Der Wafer 20 nach Fig. 1 besteht aus einem piezoelektrischen Substrat, das jeweils längs strichliniert angedeuteter Trennlinien A-A in Chips 1 vereinzelbar ist. Jeder Chip trägt auf dem ihm eigenen piezoelektrischen Substrat 1a elektrisch leitende Strukturen 2, 3 und 4, insbesondere aktive Filterstrukturen, wie z.B. Interdigitalwandler.

Auf die die elektrisch leitenden Strukturen 2, 3 und 4 tragende Chip-Fläche ist genannte PROTEC-Folie, das ist im gezeigten Ausführungsbeispiel eine mehrlagige, strukturierte Schutzfolie 5, 6, z.B. Lötstopfolie aus Polyimid, Epoxid oder Polyester, aufgetragen. Diese Folie, die dem Schutz des OFW-Bauelements gegen schädliche Umwelteinflüsse, z.B. zum Schutz gegen Staub (insbesondere leitende Partikel), aggressive chemische Substanzen und Feuchtigkeit dient, bedeckt die elektrisch leitenden Strukturen 2, 3 und 4 und die restliche Chip-Oberfläche in möglichst großen Teilbereichen.

Der durch die Miniaturisierung der OFW-Bauelemente bedingte Mangel an Platz für die Anordnung weiterer elektrisch leitender Strukturen in der Ebene der aktiven Filterstrukturen 2, 3 und 4, so insbesondere für deren Kontaktelemente 7, 11 samt Kontaktstellen 12, wird gemäß Erfindung durch Verlagerung dieser Strukturen auf die vom piezoelektrischen Substrat 1a abgekehrte Oberfläche der auch als Deckfolie bezeichneten Schutzfolie 5 behoben.

Als Deckfolie (5) eignet sich nicht nur eine der vorgenannten Lötstopfolien. Es kann auch eine dünne, strukturierbare Keramikfolie sein, die in ihrem Ausdehnungskoeffizienten an den Chip angepaßt ist, und zwar vorzugsweise an den Ausdehnungskoeffizienten in Chiplängsrichtung bzw. in Richtung der Oberflächenwellebn. Ein so mit einer Keramikfolie (5) ausgestattetes Bauelement ist bereits in sich gasdicht.

Die elektrisch leitende Verbindung der z.B. aus Cu-Schichten bestehenden Strukturen 7, 11 und ihrer Kontaktstellen 12 mit den Strukturen 2, 3 und 4 des Chips 1 erfolgt dabei über Durchkontaktierungen 8 in den Schutzfolien 5, 6, deren Öffnungen fototechnisch oder durch Laser- oder Plasma-Abtrag freigelegt sind, und in schutzfolienfreien Räumen unmittelbar über Bumps 10 genannte Lotkugeln oder Goldstückbumps. Insbesondere die letztgenannte Kontaktierung mittels Bumps, die durch Löten oder Thermokompression hergestellt werden kann, berücksichtigt das äußerst geringe Platzangebot und ermöglicht zudem eine kreuzungsfreie elektrische Verbindung zwischen den Strukturen 3 und 7. Zusätzlich wird die Gefahr, den Chip bei mechanischer oder thermischer Belastung zu deformieren, durch diese Art der Kontaktierung erheblich verringert.

Um eine Bond- bzw. Lötverbindung mit der Leiterbahn, z.B. Cu-Bahn bzw. Struktur 7, gemäß Fig. 1 zu ermöglichen, sind - betrachtet in Richtung zum Bump 10 - auf die Cu-Bahn chemisch oder galvanisch Metallschichten, z.B. aus Ni, Pd oder Au, aufgebracht, oder eine lötbare Schicht, z.B. aus Su oder SuPb.

Die streifenförmigen elektrischen Kontaktelemente 7, 11 und ihre Kontaktstellen 12 sind aus einer leitenden Cu-Schicht herausgearbeitet.

Eine elektrische Kontaktierung im Bereich der Kontaktstellen 12 mit in der Zeichnung nicht dargestellten äußeren elektrischen Anschlußelementen der Basisplatte 15 erfolgt in SMT-Technologie, und zwar bevorzugt in Chip-Mitte, d.h. in den Bereichen der Symmetrie-Achsen des Chips 1. Auch diese zur Chip-Mitte ausgerichtete Kontaktierung trägt, wie die bereits erwähnte Bump-Kontaktierung, dazu bei, daß die Deformation des Chips 1, wie sie durch die verschiedenen thermischen Ausdehnungskoeffizienten der einzelnen miteinander in Wechselwirkung stehenden Materialien auftreten kann, minimiert ist.

Die Lotkugeln bzw. Bumps sind dabei bevorzugt nach Art einer Mikro-Kugelgitterfläche (Mikro Ball Brid Array) auf den Kontaktstellen 12 angeordnet. Zusätzliche Lotkugeln auf nicht elektrisch angeschlossenen Kontaktstellen 12 tragen ferner zur erhöhten mechanischen Stabilität und Zuverlässigkeit der auf der Basisplatte 15 oder dem Schaltungsträger kontaktierten Mikro-Kugelgitterfläche bei.

Der Aufbau gemäß Fig. 3 des OFW-Bauelements schafft zusätzlich eine gasdichte Verbindung des Chips 1 mit dem Basisträger 15. Zu diesem Zweck sind die analog den Öffnungen für die Durchkontaktierungen freigelegten Stirnflächen der Schutzfolien 5, 6 in ihrem gesamten umlaufenden Bereich zwischen Basisplatte 15 und piezoelektrischem Substrat 1a durch eine Metallisierung 9 gasdicht geschlossen. Die Metallisierung 9 ist schließlich mittels Lot 17 mit einer gleichfalls entsprechend den einzelnen Chips 1 umlaufenden, lötfähigen Schicht 16 auf der Basisplatte 15 verlötet. Sollte eine zusätzliche HF-Abschirmung erforderlich sein, so kann über den Chip 1 eine Metallkappe oder eine metallbeschichtete Kunststoffkappe gestülpt werden, die mit der metallischen Schicht 16 der Basisplatte elektrisch kontaktiert ist.

## Patentansprüche

1. Elektronisches Bauelement, mit einem in Chips (1) vereinzelbaren piezoelektrischen Substrat (1a), auf dem Substrat angeordneten elektrisch leitenden Strukturen (2, 3, 4) und mit einer Basisplatte (15) mit äußeren elektrischen Anschlußelementen, die mit den elektrisch leitenden Strukturen auf dem Substrat (1a) kontaktiert sind,
bei dem über den elektrisch leitenden Strukturen (2, 3, 4) auf der sie tragenden Chip-Fläche in Teilbereichen eine mittels Phototechnik oder Laserstrukturierung strukturierte mehrlagige Schutzfolie (5, 6) zum Schutz gegen Umwelteinflüße aufgebracht ist, die auf ihrer vom piezoelektrischen Substrat (1a) abgekehrten Oberfläche streifenförmige elektrische Kontaktelemente (7, 11) trägt, die einerseits unmittelbar über Bumps (10) mit den elektrisch leitenden Strukturen (2, 3, 4) des Chips (1) und andererseits mit den elektrischen Anschlußelementen der Basisplatte (15) kreuzungsfrei verbunden sind, wobei die Kontaktelemente (7, 11) als strukturierte Leiterschicht ausgebildet und in SMT-Technologie durch Löten mit den elektrischen Anschlußelementen der Basisplatte (15) verbunden sind.

2. Elektronisches Bauelement nach Anspruch 1,
bei dem die strukturierte Leiterschicht eine Cu-Schicht ist.

3. Elektronisches Bauelement nach Anspruch 1,
bei dem die Kontaktelemente (7, 11) streifenförmig ausgebildet sind und vorwiegend mit ihren in Chip-Mitte bzw. in den Bereichen der Symmetrie-Achsen des Chips (1) befindlichen Kontaktstellen (12) mit elektrischen Anschlußelementen der Basisplatte (15) kontaktiert sind.

4. Elektronisches Bauelement nach Anspruch 1 bis 3,
bei dem die Cu-Schicht (7) im zu den Lotkugeln (10) gekehrten Bereich eine Ni-Schicht trägt, die mit einer Au-Schicht bedeckt ist.

5. Elektronisches Bauelement nach Anspruch 1,
bei dem die Schutzfolie (5, 6) eine Polyimid- oder Polyester-Folie ist.

6. Elektronisches Bauelement nach Anspruch 1,
mit einer mehrlagigen Schutzfolie (5, 6), deren Deckfolie (5) eine strukturierte Keramikfolie ist.

7. Elektronisches Bauelement nach Anspruch 1,
mit einer strukturierten Schutzfolie (6), auf die ein strukturierter Metallverbund, bestehend aus einer metallisierten Folie (7), und einer Isolationsschicht (5), laminiert ist.

8. Elektronisches Bauelement nach einem der vorhergehenden Ansprüche,
bei dem auf den Kontaktstellen (12) der elektrischen Kontaktelemente (7, 11) Lotkugeln nach Art einer Mikro-Kugelgitterfläche angeordnet sind.

9. Elektronisches Bauelement nach Anspruch 1,
bei dem die Stirnfläche der Schutzfolie (5, 6) in ihrem gesamten umlaufenden Bereich zwischen Basisplatte (15) und piezoelektrischem Substrat (1a) durch eine umlaufende Metallisierung (9) gasdicht geschlossen ist.

10. Elektronisches Bauelement nach Anspruch 9,
bei dem die Metallisierung (7) mittels Lot (17) mit einer lötfähigen Schicht (16) auf der Basisplatte (15) verlötet ist.

11. Elektronisches Bauelement nach Anspruch 1, 9 und 10, aufgebaut auf einem Wafer (20) aus Chips (1) mit jeweils umlaufender Metallisierung (9), die längs ihrer benachbarten Metallisierungen in Chips (1) auftrennbar sind.

## Claims

1. Electronic component, with a piezoelectric substrate (1a) which can be separated into individual chips (1), electrically conducting structures (2, 3, 4) arranged on the substrate and with a base plate (15) with external electrical connection elements, which are contacted with respect to the electrically conducting structures on the substrate (1a), in which component a multi-layered protective film (5, 6) which is structured by means of photolithography or laser structuring is applied over the electrically conducting structures (2, 3, 4) in subregions on the chip area bearing them, to provide protection against environmental influences, which film bears on its surface facing away from the piezoelectric substrate (1a) strip-shaped electrical contact elements (7, 11), which are connected without any crossover on the one hand to the electrically conducting structures (2, 3, 4) of the chip (1) directly by means of bumps (10) and on the other hand to the electrical connection elements of the base plate (15), the contact elements (7, 11) being formed as a structured conductor layer and connected using surface mounting technology to the electrical connection elements of the base plate (15) by soldering.

2. Electronic component according to Claim 1, in which the structured conductor layer is a Cu layer.

3. Electronic component according to Claim 1, in which the contact elements (7, 11) are of a strip form and are contacted predominantly by their contact points (12) located in the centre of the chip or in the regions of the axes of symmetry of the chip (1) with respect to electrical connection elements of the base plate (15).

4. Electronic component according to Claims 1 to 3, in which the Cu layer (7) bears in the region facing the solder balls (10) an Ni layer, which is covered by an Au layer.

5. Electronic component according to Claim 1, in which the protective film (5, 6) is a polyimide or polyester film.

6. Electronic component according to Claim 1, with a multi-layered protective film (5, 6), the covering film (5) of which is a structured ceramic sheet.

7. Electronic component according to Claim 1, with a structured protective film (6), onto which a structured metal composite, comprising a metallized film (7) and an insulating layer (5), is laminated.

8. Electronic component according to one of the preceding claims, in which solder balls are arranged on the contact points (12) of the electric contact elements (7, 11) in the manner of a micro-ball grid array.

9. Electronic component according to Claim 1, in which the end face of the protective film (5,6) is closed in a gas-impermeable manner in its entire peripheral region between the base plate (15) and the piezoelectric substrate (1a) by a peripheral metallization (9).

10. Electronic component according to Claim 9, in which the metallization (7) is soldered by means of solder (17) to a solderable layer (16) on the base plate (15).

11. Electronic component according to Claims 1, 9 and 10, built up on a wafer (20) comprising chips (1) with in each case peripheral metallization (9), which can be separated into chips (1) along its neighbouring metallizations.

## Revendications

1. Composant électronique comportant un substrat (1a) piézoélectrique pouvant être fracturé en puces (1), des structures (2, 3, 4) électriquement conductrices disposées sur le substrat et une plaque de base (15) avec des éléments de raccordement électriques extérieurs qui sont mis en contact avec les structures électriquement conductrices sur le substrat (1a), composant dans lequel une feuille protectrice (5, 6) multicouche structurée au moyen d'une technique photographique ou au laser est appliquée dans des zones partielles sur les structures (2, 3, 4) électriquement conductrices, sur la surface de puce portant celles-ci, à des fins de protection contre les influences de l'atmosphère ambiante, laquelle feuille protectrice, sur sa surface tournée à l'opposé du substrat (1a) piézoélectrique, porte des éléments de contact (7, 11) électriques en forme de bandes qui sont reliés sans croisement d'une part directement par des bossages (10) avec les structures (2, 3, 4) électriquement conductrices de la puce (1) et d'autre part avec les éléments de raccordement électriques de la plaque de base (15), les éléments de contact (7, 11) étant réalisés sous forme de couche conductrice structurée et étant reliés en technologie SMT par brasage avec les éléments de raccordement électriques de la plaque de base (15).

2. Composant électronique selon la revendication 1, dans lequel la couche conductrice structurée est une couche en Cu.

3. Composant électronique selon la revendication 1, dans lequel les éléments de contact (7, 11) sont réalisés en forme de bandes et sont mis en contact avec des éléments de raccordement électriques de la plaque de base (15), essentiellement avec leurs points de contact (12) situés au milieu de la puce ou dans les régions des axes de symétrie de la puce (1).

4. Composant électronique selon les revendications 1 à 3, dans lequel la couche de Cu (7), dans une zone tournée vers les balles de brasure (10), porte une couche de Ni qui est recouverte d'une couche de Au.

5. Composant électronique selon la revendication 1, dans lequel la feuille protectrice (5, 6) est une feuille en polyimide ou en polyester.

6. Composant électronique selon la revendication 1, avec une feuille protectrice (5, 6) multicouche dont la feuille de recouvrement (5) est une feuille céramique structurée.

7. Composant électronique selon la revendication 1, avec une feuille protectrice (6) structurée sur laquelle est laminé un composé métallique structuré formé d'une feuille (7) métallisée et d'une couche isolante (5).

8. Composant électronique selon une des revendications précédentes, dans lequel des balles de brasure sont disposées à la manière d'un réseau de micro-balles sur les points de contact (12) des éléments de contact (7, 11) électriques.

9. Composant électronique selon la revendication 1, dans lequel la face frontale de la feuille protectrice (5, 6) est fermée de manière étanche aux gaz par une métallisation (9) périphérique dans toute sa région périphérique située entre la plaque de base (15) et le substrat (1a) piézoélectrique.

10. Composant électronique selon la revendication 9, dans lequel la métallisation (7) est brasée au moyen d'un métal d'apport de brasage (17) avec une couche (16) brasable sur la plaque de base (15).

11. Composant électronique selon les revendications 1, 9 et 10, construit sur une tranche de silicium (20) formée de puces (1) ayant chacune une métallisation (9) périphérique, tranche qui peut être divisée en puces (1) le long des métallisations voisines.
